# EUROPEAN PATENT SPECIFICATION

(11) **EP 1 125 365 B1**
(45) Date of publication and mention of the grant of the patent: **02.11.2006**
(21) Application number: 99936639.6
(22) Date of filing: 30.07.1999
(51) Int. Cl.: H03K 17/08

(54) **PROTECTION AGAINST OVERVOLTAGE PEAK**
SCHUTZ GEGEN ÜBERSPANNUNGSSPITZEN
PROTECTION CONTRE LES PICS DE SURTENSION

(30) Priority: 31.07.1998 FI 981687
(43) Date of publication of application: 22.08.2001
(73) Proprietor: Oy Lexel Finland AB, 02125 Espoo (FI)
(72) Inventor: SAIRANEN, Martti, FIN-01700 Vantaa (FI); ABERG, Kari, FIN-00640 Helsinki (FI)
(74) Representative: Tanhua, Pekka Vilhelm
(86) International application number: PCT/FI1999/000647
(87) International publication number: WO 2000/008760

(56) References cited:
- EP-A1- 0 523 800
- EP-A2- 0 272 898
- PATENT ABSTRACTS OF JAPAN & JP 05 276 650 A (SHIN KOBE ELECTRIC MACH CO LTD) 22 October 1993

## Description

The present invention as it is defined in the independent claims relates to a method and apparatus for protecting electric appliances against interference, particularly overvoltage peaks, occurring therein.

Overvoltage peaks are single, extremely rapid voltage peaks, the maximum magnitude whereof may rise over 500 volts, their duration being of the order 1-5 µs. Such single voltage peaks contain a lot of energy, in which case an interference peak may damage the device in question. Switches that are provided in various devices are particularly susceptible to damage.

The above described drawback occurs particularly in field effect transistors, which are often used as switches in dimmer applications. In that case the supply voltage or a corresponding AC voltage is connected to one side of the field effect transistor switching unit, and respectively the load is connected to the other side of said field effect transistor switching unit. In this respect, we refer for example to the Finnish patent application 945,095. Load current proceeds in a channel between the drain and source of one or several field effect transistors, and said channel is regulated to conductive/non-conductive state, i.e. to on/off positions periodically during the half-cycle of the AC voltage by means of a control voltage arranged on the field effect transistor grid. From time to time, the dimmer may receive overvoltage peaks of the above described type from the electrical network. Overvoltage peaks occur also when turning off a fluorescent lamp. If the overvoltage peak is sufficiently strong, the field effect transistor switching unit is broken down.

Field effect transistors, FETs, are today used generally in many different switch applications. The structure of a field effect transistor is normally such that it contains a large number of small field effect transistor chips processed on one and the same semiconductor piece, said chips being arranged to function together in parallel. When realised in this fashion, the switching properties and the current resistance of the field effect transistor have been remarkably improved in comparison with the single-chip field effect transistors.

However, drawbacks with said field effect transistors are sudden, strong overvoltage peaks which, when occurring over a field effect transistor that is cut off, i.e. non-conductive, destroy said field effect transistor. In principle the mechanism of destruction is such that the breakdown begins with one field effect transistor chip and spreads to others therefrom. In that case, particularly said point-like starting spot is destroyed in the field effect transistor, whereafter the transistor does not function in an appropriate manner anymore.

Nowadays there are known components and circuit arrangements whereby an electronic circuit or component can be protected against overvoltage peaks. One such method, applied particularly in connection with switches, is to switch a varistor over the switch in order to eliminate the overvoltage peak. However, a problem in the use of a varistor is that it is a physically large component, in which case it cannot be used in small devices. Particularly problematic the use of a varistor is for instance in connection with dimmers, because they are often placed in a small box, where the use of a varistor is impossible. The document Patent Abstracts of Japan & JP 05 276 650 A (Shir Kobe Electric Mach Co Ltd) 22 October 1993 describes another protection circuit.

The object of the invention is to introduce a method whereby particularly a field effect transistor switching unit serving as a switch can be protected against overvoltage peaks. Another object of the invention is to introduce a simple apparatus for protecting said field effect transistor switching unit.

The protection methods according to the invention are characterised by what is disclosed in the characterising part of the independent claims 1 and 2. The devices according to the invention are characterised by what is disclosed in the characterising part of the independent claims 3 and 5. Other preferred embodiments according to the invention are disclosed in the dependent claims.

An advantage of the invention is that the overvoltage peak of the field effect transistor switching unit can be realised in a simple and feasible manner. Owing to the invention, the field effect transistor switching unit is reliably protected against overvoltage peaks, so that for instance a field effect transistor used in dimmer applications is not destroyed due to an overvoltage peak. As a result of the protection according to the invention, a field effect transistor may endure several hundreds, even thousands of such random overvoltage peaks.

An advantage of the apparatus according to the invention is that it can be realised by means of just a few electronic components. Another advantage is that it can be fitted in a small space, and thus it is suited to be used particularly in connection with such field effect transistors that are arranged for instance in a dimmer, as regulating switches of the AC current.

The invention is explained below with respect to the appended drawings, where
- figure 1: is a block diagram illustrating a switching unit and a protective arrangement according to the invention,
- figure 2a: illustrates the occurrence of an overvoltage peak in a rectified supply voltage,
- figure 2b: illustrates the wave pattern of the dimmer load voltage,
- figure 2c: illustrates the voltage prevailing over the switching unit,
- figure 3: illustrates in a circuit diagram the switching unit realised by means of a field effect transistor and a protective arrangement according to the invention,
- figure 4: illustrates a protective arrangement according to the invention in the power regulator of a light source, and
- figure 5: illustrates the curve form of the supply voltage fed in the power regulator of figure 4.

Like numbers for like parts are used in the drawings.

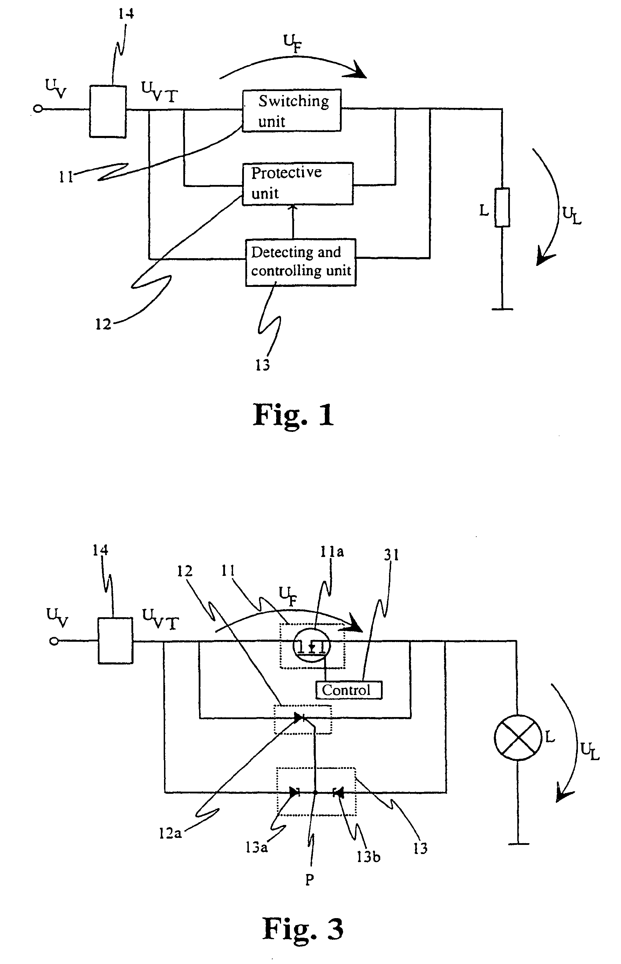

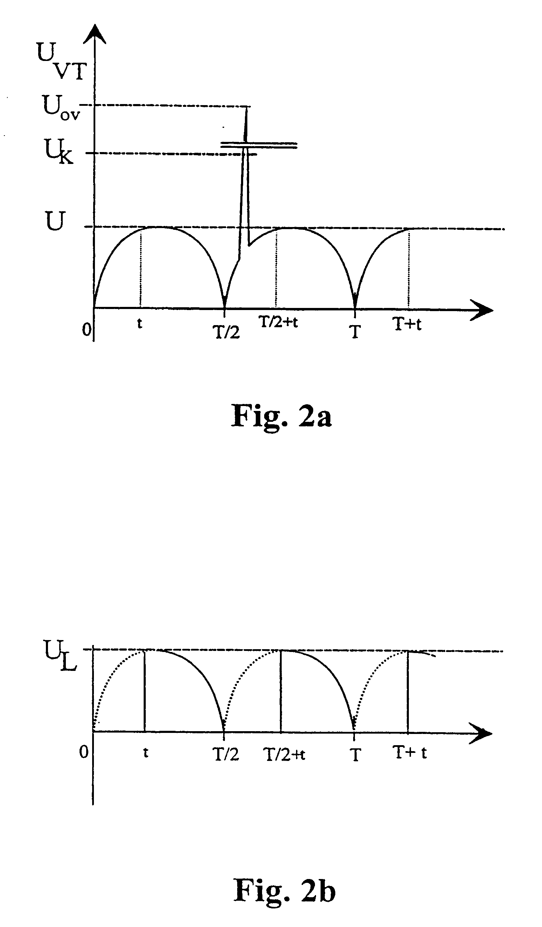

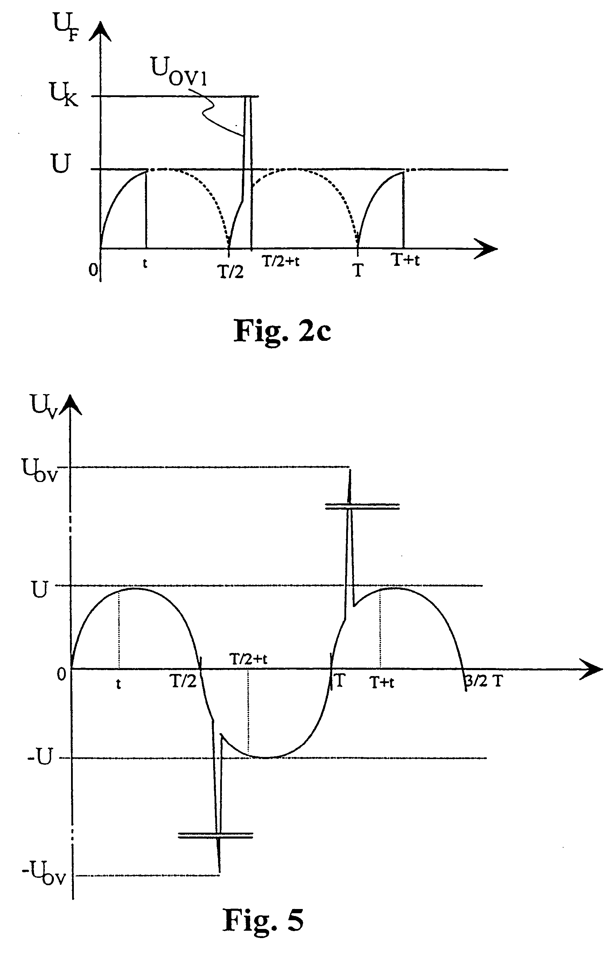

Figure 1 is a block diagram illustrating the arrangement according to the invention for protecting the switching unit 11 against overvoltage peaks. The switching unit 11 may comprise one or several field effect transistors. The AC voltage U_{V} is taken from the mains or from a corresponding AC source and fed in a rectifier 14. In this case the rectified AC voltage U_{VT}, figure 2a, obtained from the rectifier 14, is fed further, here via the switching unit 11, to the load L. By means of the switching unit 11, the AC power of the load L is regulated. The load L is connected to the mains during the half-cycle T/2 of the supply voltage U_{V} at a point of time t (counted from the beginning of the half-cycle) by switching the switching unit 11 to conductive state, said point of time t always taking place the earlier (nearer to the beginning of the half-cycle), the larger the desired AC power fed in the load L is, and respectively off the mains at the end of the half-cycle, while the supply voltage is 0. The curve form of the voltage U_{L} prevailing over the load L is illustrated in figure 2b. The voltage U_{F} prevailing over the switching unit 11 is illustrated in figure 2c. Thus the switching unit 11 is non-conductive during the periods 0, t and T/2, T/2+t and respectively conductive during the rest of the half-cycles, i.e. the periods t, T/2 and T/2+t, T.

If an overvoltage peak occurs in the supply voltage U_{V} and further in the rectified supply voltage U_{VT} during the time, when the switching unit is non-conductive, i.e. during the period 0, t and T/2, T/2+t (figure 2b), it destroys the switch provided in the switching unit 11. In order to prevent this, in the coupling of figure 1, there is arranged an overvoltage protection according to the invention. It advantageously comprises another switching unit, i.e. a protective switching unit 12, coupled in parallel with the switching unit 11, and by means of said unit 12, the switching unit 11 proper is protected; as well as a detecting and controlling unit 13 for detecting overvoltage peaks and for further controlling the protective switching unit 12 coupled in parallel with the switching unit 11 proper. According to a preferred embodiment of the invention, the same detecting and controlling unit 13 can also control the switching unit 11 proper. Advantageously the detecting and controlling unit 13 comprises means for controlling the voltage U_{F} prevailing over the switching unit and for sending a control signal on the basis of the magnitude of the voltage difference.

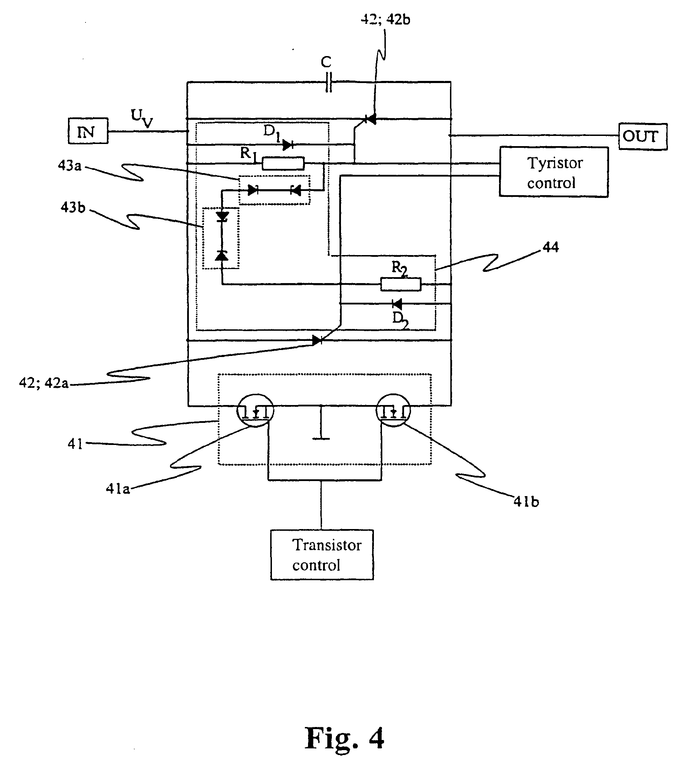

Figure 3 illustrates an overvoltage protection arrangement for protecting the field effect transistor 11a serving as a switch against overvoltage peaks. In this preferred embodiment, the switching unit 11 comprises only one field effect transistor 11 a, but there can also be several switches coupled in series and/or in parallel. The supply voltage U_{V} or a corresponding AC current source is coupled via a rectifier 14, such as a diode rectifier, to the input pole of the field effect transistor switch 11a. The switch of the protective switching unit 12, which in this preferred embodiment is a tyristor 12a, is further coupled over the field effect transistor switch 11 a, in the forward direction, from the input pole to the output pole thereof. Respectively, the detecting and controlling unit 13 of the protective switch is advantageously coupled to in between the input and output pole of the field effect transistor switch 11a.

It is obvious for a man skilled in the art that if the switching unit 11 comprises more than one field effect transistor 11a, the protective switching unit 12 and the detecting and controlling unit 13 are coupled over all said field effect transistor switches, so that the first end thereof is at the input pole of the first field effect transistor switch, and the other end is at the output pole of the last field effect transistor serving as a switch. The installation of the protective switching unit 12 and of the detecting and controlling unit 13 in parallel with the switching unit 11 proper can also be realised in some other fashion than what is described above, provided that it is suitable for the other elements of the arrangement.

Advantageously the detecting and controlling unit 13 comprises at least two zener diodes 13a and 13b, coupled in series and conductive in opposite directions. Said diodes serve as voltage references over the switching unit 11. When the voltage reference created by the zener diodes 13a, 13b is surpassed, the control is given over to the protective switching unit 12, which immediately switches over to conductive state. The protective unit can be for instance a tyristor 12a, which reacts rapidly to a control signal. Another possibility is to utilise a triac, for example, but for a man skilled in the art it is obvious that as the protective switch, there can also be employed any other component that is by its function suitable to replace the tyristor 12a that is above described by way of example. Likewise, it is obvious for a man skilled in the art that the number of the zener diodes in the overvoltage detecting and controlling unit 13 is by no means restricted, but several zener diode pairs according to the above description can be coupled in series when necessary. Figure 3 also illustrates a field effect transistor control circuit 31, which as such does not form part of the invention and shall not be discussed further in this connection.

Let us now describe the operation of the overvoltage protection arrangement in more detail with reference to figures 2a, 2c and 3. When there occurs a strong overvoltage peak U_{OV} in the supply voltage U_{V} and further in the rectified supply voltage U_{VT}, and it occurs at a point of time in the supply voltage half-cycle when the field effect transistor 11a serving as the switch is non-conductive, the overvoltage peak causes a strong voltage rise U_{OV1} over the switching unit 11a serving as the switch, and said peak is detected in the detecting and controlling unit 13. This means that at the intermediate point P formed between the connected cathodes of the zener diodes 13a, 13b, the voltage conforms to the voltage rise U_{OV1} and rises abruptly and surpasses the predetermined threshold voltage value U_{K}, which is for example 400 V. When the threshold voltage U_{K} is surpassed, the detecting and controlling unit 13 sends a control signal to the protective switching unit 12, which is for instance a tyristor 12a. After receiving the control signal, the tyristor 12a becomes conductive and thus lets the overvoltage peak U_{OV} directly through to the load L, which here is a lighting fixture load. Thus the overvoltage peak U_{OV} does not break the non-conductive field effect transistor 11a of the switching unit. It is pointed out that the detecting and controlling unit 13 is arranged to operate extremely rapidly, and it is capable of detecting fast overvoltage peaks, so that there is time to conduct the overvoltage peak via the protective switching unit 12 to the load before it damages the field effect transistor switch 11a which is slower than the protective arrangement. When the overvoltage peak has passed through the tyristor 12a serving as the protective switch, it is conductive as far as then next 0 point of the current, when it is again set to non-conductive state. Figure 2c illustrates the voltage U_{F} over the switching unit 11, particularly when the overvoltage peak U_{OV} occurs in a rectified supply voltage U_{VT} according to figure 2a.

Figure 4 illustrates an advantageous application for a preferred embodiment of the invention. The device in question is an electronic power regulator that can be used for instance in regulating the light power of a lighting fixture. Said electronic power regulator is described in more detail for example in the Finnish patent application 964,021. Here we concentrate mainly on the switching unit of the power regulator, which switching unit comprises a field effect transistor switching unit 41 and a tyristor switching unit 42, coupled in parallel. In this embodiment, the field effect transistor switching unit 41 is formed of two field effect transistors 41a, 41b. The source poles of the field effect transistors 41a, 41b are coupled together and the drain poles to the input pole of the power regulator, i.e. to the supply voltage input pole (IN), and respectively to the output pole, i.e. to the load connection pole (OUT) according to figure 4. The tyristor switching unit 42 comprises two tyristors 42a, 42b, which are coupled to operate in opposite directions according to the above description, in between the input pole (IN) and the output pole (OUT). In this exemplary embodiment, on the grids of the tyristors 42a, 42b, there are coupled two zener diode pairs 43a, 43b, whereby the voltage between the input pole (IN) and the output pole (OUT) is measured, and which together with the diodes D₁, D₂ and resistors R₁, R₂ constitute the voltage detecting and controlling unit 44. It is pointed out that to this switching unit, there is directly fed supply voltage U_{V} or a corresponding AC voltage (figure 5). When the reference or threshold voltage U_{K} defined by the zener diode pairs 43a, 43b is surpassed, i.e. an overvoltage peak U_{OV} occurs during a positive half-cycle of the supply voltage, the tyristor 42a is controlled via the diode D₁, i.e. the zener diode pairs 43a, 43b, in which case it becomes conductive and lets the overvoltage peak U_{OV} directly through, to the load (OUT). If, on the other hand, a predetermined negative reference voltage -U_{K} is surpassed owing to a negative overvoltage peak - U_{OV} during a negative half-cycle of the supply voltage, while the field effect transistor switching unit 41 is open, i.e. non-conductive, the tyristor 42b obtains on the grid a control signal via the diode D₂ as well as via the zener diode pair 43a, 43b and switches to conductive state, in which case the overvoltage peak - U_{OV} proceeds via the tyristor 42b directly to the load (OUT).

It is essential to point out that by means of the zener diode pairs 43a, 43b of the voltage detecting and controlling unit 44, there is defined the limit magnitude for the threshold voltage ±U_{K}, so that when said limit is surpassed, the overvoltage peak ±U_{OV} is conducted directly to the load via the tyristors 42a, 42b. Because the zener diode pairs each comprise two zener diodes facing each other, the magnitude of the threshold voltage ±U_{K} can be defined essentially so that it is the sum of all breakdown voltages occurring in the non-conducting direction with respect to the overvoltage peak, i.e. for instance in this embodiment of the invention, there are two zener diode pairs 43a, 43b, and consequently in each situation there are two zener diodes in the non-conducting direction, and said diodes defme the magnitude of the threshold voltage U_{K}. If the breakdown voltage of a single zener diode is for example 230 V, then in the arrangement illustrated in figure 4, the threshold voltage is about 460 V (230 V + 230 V). For a man skilled in the art, it is obvious that the number of the zener diode pairs can advantageously be used in order to adjust the threshold voltage U_{K} to be suitable for each application. Let it be understood that the voltage detecting and controlling unit 44 also includes other components that may affect the magnitude of the threshold voltage U_{K}; however, the zener diode pairs 43a, 43b are essential components owing to the simplicity and efficiency of the circuit.

We shall not discuss in more detail other components illustrated in the arrangement of figure 4 but not mentioned above - such as the condensator C - because they are not essentially connected to the invention introduced in this patent application. A man skilled in the art understands that the arrangement of figure 4 is simplified, in order to better illustrate the idea of the novel invention introduced herein.

In the above description, the invention is described with reference to exemplary arrangements used in the lighting fixture technology. It is clear, for a man skilled in the art, that the present invention can in all parts be applied to other arrangements containing a risk that an overvoltage peak received from the mains might break the field effect transistors serving as switches in said arrangement.

The above described components are by no means restricted to certain types, but in connection with the invention, it is also possible to use other components that are advantageously suitable for providing the protection according to the invention, and which are possible within the inventive idea defined in the appended claims.

## Claims

1. A method for protecting a switching unit (11; 41) against overvoltage peaks, said switching unit (11; 41) comprising a field effect transistor switching unit (11; 41) and a tyristor switching unit (12; 42) coupled in parallel, **characterized in that**
- in order to detect an overvoltage peak (U_{OV}), the voltage (U_{F}) prevailing over the switching unit (11; 41) is observed, particularly when the switching unit (11; 41) is non-conductive.
- when the voltage (U_{F}) prevailing over the switching unit (11; 41) suddenly surpasses the predetermined threshold voltage (U_{K}), so that it is interpreted as an overvoltage peak (U_{OV}), the tyristor switching unit (12; 42) is switched to conductive state, in which case the overvoltage peak (U_{OV}) is made to proceed through the tyristor switching unit (12; 42) serving as the protective switching unit (12; 42).

2. An apparatus for protecting a field effect transistor switching unit (11; 41) against an overvoltage peak (U_{OV}), said switching unit (11; 41) comprising a field effect transistor switching unit (11; 41) and a tyristor switching unit (12; 42), coupled in parallel, **characterized in that** the apparatus includes a voltage detecting and controlling unit (13; 44) in order to observe the voltage (U_{F}) prevailing over the switching unit (11; 41), in order to detect an overvoltage peak (U_{OV}) and in order to control the tyristor switching unit (12; 42) as a protective switching unit (12; 42), so that the overvoltage peak (U_{OV}) is set to proceed via the tyristor switching unit (12; 42) immediately after the overvoltage peak (U_{OV}) is detected.

3. An apparatus according to claim 2, **characterized in that** the voltage detecting and controlling unit (13, 44) comprises at least two zener diodes (13a, 13b; 43a, 43b) coupled in series and conductive in opposite directions, and that the detecting of the voltage (U_{F}) prevailing over the switching unit (11; 41) takes place in between said zener diodes.

## Patentansprüche

1. Verfahren zum Schutz einer Schalteinheit (11; 41) vor Überspannungsspitzenwerten; wobei die Schalteinheit (11; 41) eine Feldeffekttransistor-Schalteinheit (11; 41) und eine Thyristor-Schalteinheit (12; 42) umfasst, die parallel geschaltet sind,
**dadurch gekennzeichnet, dass**
- um einen Überspannungsspitzenwert (U_{OV}) zu erfassen, die über die Schalteinheit (11; 41) anliegende Spannung (U_{F}) beobachtet wird, insbesondere, wenn die Schalteinheit (11; 41) nichtleitend ist,
- wenn die über der Schalteinheit (11; 41) anliegende Spannung (U_{F}) plötzlich die vorbestimmte Schwellenspannung (U_{K}) übertrifft, so dass sie als ein Überspannungsspitzenwert (U_{OV}) interpretiert wird, die Thyristor-Schalteinheit (12; 42) in den leitenden Zustand geschaltet wird, in welchem Fall veranlasst wird, dass der Überspannungsspitzenwert (U_{OV}) durch die Thyristor-Schalteinheit (12; 42) tritt, welche als die Schutz-Schalteinheit (12; 42) dient.

2. Vorrichtung zum Schutz einer Feldeffekttransistor-Schalteinheit (11; 41) gegen einen Überspannungsspitzenwert (U_{OV}), wobei die Schalteinheit (11; 41) eine Feldeffekttransistor-Schalteinheit (11; 41) und eine Thyristor-Schalteinheit (12; 42) umfasst, die parallel geschaltet sind,
**dadurch gekennzeichnet, dass** die Vorrichtung eine Spannungs-Erfassungs- und -Steuer-/Regeleinheit (13; 44) umfasst, um die an der Schalteinheit (11; 41) anliegende Spannung (U_{F}) zu beobachten, um einen Überspannungsspitzenwert (U_{OV}) zu erfassen, und um die Thyristor-Schalteinheit (12; 42) als eine Schutz-Schalteinheit (12; 42) derart zu steuern/regeln, dass der Überspannungsspitzenwert (U_{OV}) derart eingestellt wird, dass er unmittelbar, nachdem der Überspannungsspitzenwert (U_{OV}) erfasst ist, über die Thyristor-Schalteinheit (12; 42) verläuft.

3. Vorrichtung nach Anspruch 2, **dadurch gekennzeichnet, dass** die Spannungs-Erfassungs- und -Steuer-/Regeleinheit (13; 44) wenigstens zwei Zenerdioden (13a, 13b; 43a, 43b) umfasst, die in Reihe geschaltet sind und in entgegengesetzte Richtungen leitfähig sind, und dass das Erfassen der über die Schalteinheit (11; 41) anliegenden Spannung (U_{F}) zwischen den Zenerdioden stattfindet.

## Revendications

1. Procédé destiné à protéger un équipement de commutation (11 ; 41) contre les pics de surtension, ledit équipement de commutation (11. ; 41) comprenant un équipement de commutation de transistor à effet de champ (11 ; 41) ainsi qu'un équipement de commutation de thyristor (12 ; 42) couplés en parallèle, **caractérisé en ce que**
- afin de détecter un pic de surtension (U_{OV}), la tension (U_{F}) prévalant sur l'équipement de commutation (11 ; 41) est observée, en particulier lorsque l'équipement de commutation (11 ; 41) est non conducteur.
- lorsque la tension (U_{F}) prévalant sur l'équipement de commutation (11; 41) dépasse soudainement la tension de seuil prédéterminée (U_{K}), de sorte qu'elle est interprétée en tant que pic de surtension (U_{OV}), l'équipement de commutation de thyristor (12 ; 42) est commuté sur l'état conducteur, dans quel cas le pic de surtension (U_{OV}) est forcé de circuler à travers l'équipement de commutation de thyristor (12 ; 42) servant d'équipement de commutation de protection (12 ; 42).

2. Appareil destiné à protéger un équipement de commutation de transistor à effet de champ (11 ; 41) contre un pic de surtension (U_{OV}), ledit équipement de commutation (11 ; 41) comprenant un équipement de commutation de transistor à effet de champ (11 ; 41) ainsi qu'un équipement de commutation de thyristor (12 ; 42) couplés en parallèle, **caractérisé en ce que** l'appareil comprend une unité de détection et de contrôle de la tension (13 ; 44) afin d'observer la tension (U_{F}) prévalant sur l'équipement de commutation (11 ; 41), afin de détecter un pic de surtension (U_{OV}) et afin de contrôler L'équipement de commutation de thyristor (12 ; 42) en tant qu'équipement de commutation de protection (12 ; 42), de sorte que le pic de surtension (U_{OV}) est régler pour circuler via l'équipement de commutation de thyristor (12 ; 42) immédiatement après que le pic de surtension (U_{OV}) soit détecté.

3. Appareil selon la revendication 2, **caractérisé en ce que** l'unité de détection et de contrôle de la tension (13 ; 44) comprend au moins deux diodes Zener (13a, 13b ; 43a, 43b) couplées en série et conductrices dans des directions opposées et **en ce que** la détection de la tension (U_{F}) prévalant sur l'équipement de commutation (11 ; 41) a lieu entre lesdites diodes Zener.
